# EUROPEAN PATENT SPECIFICATION

(11) **EP 4 700 396 B1**
(45) Date of publication and mention of the grant of the patent: **18.11.2026**
(21) Application number: 24196320.6
(22) Date of filing: 23.08.2024
(51) Int. Cl.: G01R 1/20, G01R 15/20

(54) **BUS BAR FOR REDUNDANT CURRENT SENSOR SYSTEM**
STROMSCHIENE FÜR REDUNDANTES STROMSENSORSYSTEM
BARRE OMNIBUS POUR SYSTÈME DE CAPTEUR DE COURANT REDONDANT

(43) Date of publication of application: 25.02.2026
(73) Proprietor: Melexis Technologies SA, 2022 Bevaix (CH)
(72) Inventor: TOMBEZ, Lionel, 2022 Bevaix (CH); BOURY, Bruno, 3980 Tessenderlo (BE)
(74) Representative: Winger

(56) References cited:
- WO-A1-2024/142703
- US-A1- 2023 266 368
- US-A1- 20240 036 082

## Description

### Field of the invention

The present invention relates to the field of current sensing, and more specifically to redundant current sensing with improved thermal performance and reduced voltage offset.

### Background of the invention

The field of current sensing has seen significant advancements in recent years, with various technologies being employed to accurately measure electrical current in a wide range of applications. These applications span from power management systems in industrial settings to battery monitoring in electric vehicles. Accurate current measurement is crucial for ensuring the safe and efficient operation of electrical systems, as well as for enabling advanced features such as fault detection and energy optimization.

One common approach to current sensing involves the use of shunt resistors, where the voltage drop across a known resistance is measured to determine the current flow. Another popular technique is the use of magnetic sensors, such as Hall-effect sensors, which detect the magnetic field generated by the current flowing through a conductor. Each of these methods has its own advantages and limitations in terms of accuracy, linearity, isolation, and cost.

However, despite the progress made in current sensing technologies, there remain significant challenges that need to be addressed. One major issue is the impact of temperature variations on the accuracy of current measurements. Both shunt resistors and magnetic sensors are susceptible to temperature-induced errors, which can lead to inaccurate readings and potentially compromise the performance and safety of the electrical system. Another challenge is the need for high-precision measurements over a wide dynamic range, particularly in applications involving high currents or rapidly changing current levels.

Furthermore, as electrical systems become more complex and distributed, there is a growing demand for current sensing solutions that offer improved reliability, redundancy, and fault tolerance. In safety-critical applications, such as automotive and aerospace systems, the ability to detect and isolate sensor failures is very important. This requires the development of advanced sensor architectures and signal processing techniques that can provide multiple layers of protection against measurement errors and system faults.

In light of these challenges, there is a clear need for further advancements in the field of current sensing to address the limitations of existing technologies and meet the evolving requirements of modern electrical systems, to improve the accuracy, stability, and robustness of current measurements across a wide range of operating conditions. WO 2024/142703 A1 discloses a current detector having a bus bar through which a current to be measured flows.

### Summary of the invention

It is an object of embodiments of the present invention to provide a bus bar for current sensing, as disclosed in the appended claims.

It is an advantage that the offset voltage due to the Seebeck effect at the junction of a shunt is reduced, allowing accurate redundant sensing.

In some embodiments the structure comprises a further portion with the same thermal resistance as the second portion along the bus bar at each sides of the first conductive portion. Less ohmic portions than magnetic portions may be advantageously provided, e.g. less shunt resistors, e.g. a single shunt resistor.

In some embodiments the bus bar comprises a further portion with the same thermal resistance as the first portion, the first and further portions surrounding the second portion. It is an advantage that the bus requires magnetic portions, hence less geometric adaptations. It is an advantage of some embodiments that the resistance of the further portion can be accurately provided.

In some embodiments second and further portions comprise a hole, a narrowing or a combination of both. It is an advantage of embodiments of the present invention that the cross section can be easily reduced to increase the magnetic field.

In some embodiments the further portion comprises a shunt so as to provide the same thermal resistance as the first portion. It is an advantage of embodiments of the present invention that a balanced thermal flux in opposite directions can be obtained so they substantially cancel each other along the one or more shunts, so that there is little or no offset voltage due to the Seebeck effect.

In some embodiments the bus bar is geometrically symmetrical over its center. It is an advantage of embodiments of the present invention that a thermally balanced bus bar can be easily obtained.

In some embodiments the shunt resistor is made of a material with a low temperature coefficient. It is an advantage of embodiments of the present invention that a low temperature coefficient provides low Seebeck effect, thus low offset voltage.

In some embodiments the shunt resistor comprises manganese.

It is an advantage of embodiments of the present invention that Mn can form a good resistor with suitable temperature coefficient.

In some embodiments the bus bar is made of copper. It is an advantage of embodiments of the present invention that copper is a well known material for bus bars in the art.

In a further aspect, a system for measuring current is provided. The system comprises the bus bar of the present invention, and:
- a voltage sensing circuit configured to obtain a voltage drop on the first portion through the shunt
- a magnetic sensing means configured to measure the magnetic field at the second portion, and
- a processing unit configured to process the signals from the voltage sensing circuit and the magnetic sensing means to determine the current flowing in the bus bar.

It is an advantage of embodiments of the present invention that an accurate current sensor can be obtained with redundancy unaffected by the offset voltage.

In some embodiments the voltage sensing circuit and magnetic sensing means are provided in the same integrated circuit. It is an advantage of embodiments of the present invention that an integrated sensor with compact electronics can be provided
In a further aspect, the present invention provides a method of measuring current using a bus bar of the first aspect, as disclosed in the appended claims.

In some embodiments the method further comprises combining and/or comparing the two signals to provide a reading of the current.

It is an advantage that a redundant signal can be provided to obtain the current in two different ways, thus allowing calibration and high accuracy.

In some embodiments measuring the magnetic field comprises using a Hall effect sensor.

It is an advantage that a Hall sensor can be implemented easily, with or without shielding, as a current sensor.

In a further aspect, the present invention provides a kit of parts for measuring current, comprising:
- the bus bar of the first aspect of the present invention,
- a voltage sensing circuit configured to obtain a voltage drop through the shunt and a magnetic sensor configured to measure the magnetic field at the necking or hole,
- a processor connectable to the voltage and magnetic sensors.

Particular and preferred aspects of the invention are set out in the accompanying independent and dependent claims. Features from the dependent claims may be combined with features of the independent claims and with features of other dependent claims as appropriate and not merely as explicitly set out in the claims.

These and other aspects of the invention will be apparent from and elucidated with reference to the embodiment(s) described hereinafter.

### Brief description of the drawings

Fig. 1 is a view of a prior art redundancy sensor according to embodiments of the prior art.
Fig. 2 is a view of a bus bar with two shunt resistors and a necking according to embodiments of the present invention.
Fig. 3 is a view of a bus bar with a central shunt resistor and two neckings according to embodiments of the present invention.
Fig. 4 and Fig. 5 are a view of a respective bus bar with holes instead of neckings according to embodiments of the present invention, with different geometries.
Fig. 6 is a view of a bus bar with two holes, a shunt resistor, and a shielded magnetic sensor according to embodiments of the present invention.
Fig. 7 and Fig. 8 are a schematic view of an external microcontroller unit (MCU) connected to a bus bar according to embodiments of the present invention.
Fig. 9 is a schematic flowchart with the steps of the method in accordance with embodiments of the present invention.

In the different figures, the same reference signs refer to the same or analogous elements.

The drawings are only schematic and are non-limiting. In the drawings, the size of some of the elements may be exaggerated and not drawn on scale for illustrative purposes.

Any reference signs in the claims shall not be construed as limiting the scope.

### Detailed description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

The following terms are provided solely to aid in the understanding of the invention.

As used herein, and unless otherwise specified, the term "bus bar" refers to an electrical conductor that carries a substantial current, often used for power distribution in electrical systems. The bus bar may be made of a conductive material such as copper or aluminum and can have various shapes and sizes depending on the specific application. The bus bar may have connections, contacts or in general terminals at its opposite ends, so there is a current in the bus bar between the connections when each is connected to an external circuit or power line(s).

As used herein, and unless otherwise specified, the term "shunt resistor" refers to a low-resistance resistor used to measure electrical current by means of the voltage drop across the resistor. The resistor may be a precision resistor. The shunt resistor is typically connected in series with the load, for example in series between two portions of the bus bar. The shunt resistor is configured to cause a measurable difference of potential (voltage drop) along the bus bar at each side of the shunt resistor. The current flowing through the shunt resistor can be determined by measuring the voltage drop across the shunt resistor and applying Ohm's law.

As used herein, and unless otherwise specified, the term "thermal resistance" refers to a measure of a material's ability to resist heat flow. It is defined as the temperature difference across the material divided by the heat flux (heat transfer per unit area) through the material. Materials with high thermal resistance are good thermal insulators, while materials with low thermal resistance are good thermal conductors.

As used herein, and unless otherwise specified, the term "low temperature coefficient" refers to a property of materials whose electrical resistance does not change significantly with temperature. Shunt resistors made from or comprising materials with low temperature coefficients, such as manganese, are preferred for accurate current measurements over a wide temperature range.

As used herein, and unless otherwise specified, the term 'magnetic sensing means' include for example magnetic sensors in various technologies, such as: Hall effect (horizontal Hall plates, and/or vertical Hall plates), magneto-resistance, such giant magneto-resistance (GMR), tunnel magneto-resistance (TMR), giant magneto-impedance (GMI) and fluxgates. For example, the magnetic sensing means includes one or more integrated magnetic sensors formed as one or more integrated circuits (ICs), for example using CMOS technologies. The magnetic sensing means may include a packaged magnetic sensor, such as an overmolded semiconductor integrated sensor comprising one or more semiconductor dice. Magnetic sensing means usually include a sensing element using one or more of the previously described technologies, in combination with processing electronics, including analog and/or digital signal processing connected to the sensing element(s) and configured for outputting a signal indicative of a magnetic field.

As used herein, and unless otherwise specified, the term "necking" or "narrowing" refers to a localized reduction in the cross-sectional area of the bus bar. Usually this means a reduction of the width of the bus bar, however this is not the only possibility, and a thickness reduction (perpendicular to the direction of the current) could be applied. A reduction of the cross-sectional area can be used to locally increase the magnetic field strength, on which sensing elements of magnetic sensing means can be placed and aligned to such areas. This improves the sensitivity and accuracy of magnetic field measurements and, thus, current measurements.

As used herein, and unless otherwise specified, the term "magnetic shielding" refers to materials or structures used to reduce the influence of external magnetic fields on magnetic sensing. Magnetic shielding can be made from high-permeability materials such as mu-metal or permalloy and is used to enclose the sensitive components of the current measurement system, ensuring accurate readings by minimizing interference from external magnetic sources.

The invention will now be described in detail by reference to several embodiments of the invention. It is clear that other embodiments of the invention can be configured according to the knowledge of persons skilled in the art without departing from the technical teaching of the invention, the invention being limited only by the terms of the appended claims.

The invention relates to a bus bar with features that allow current measurement by using different physical principles. This is known as redundancy. The current through the bus bar can be measured by, on one hand, measuring the voltage drop through the bus bar and on the other, measuring the magnetic field caused by the current. Such bus bar can be adapted to optimize these measurements.

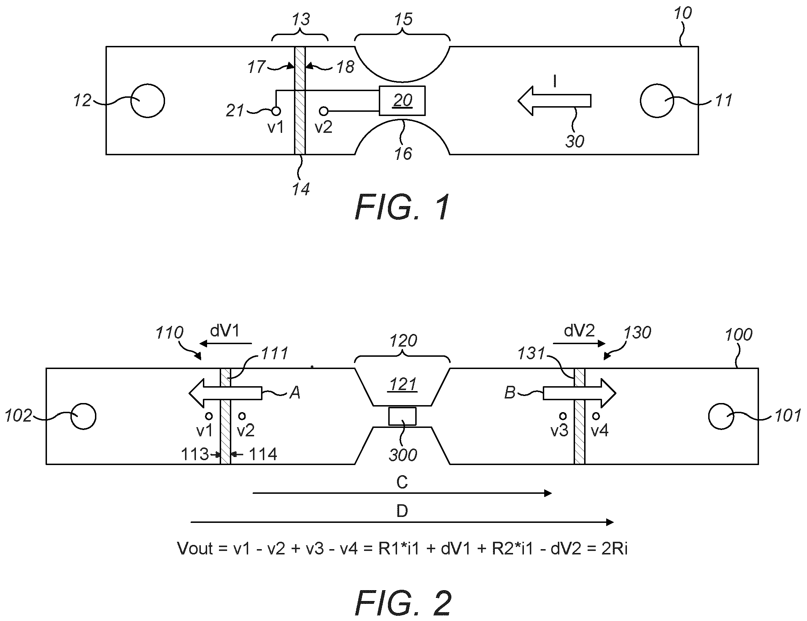

Fig. 1 shows an existing redundancy sensor 20 according to embodiments of the prior art. The sensor 20 senses the current through a bus bar 10. Said bus bar includes two terminals 11, 12, and a current 30 flows between the terminals through the bar. A first portion 13 of the bus bar, or 'ohmic portion', is defined as the portion where the sensor measures the voltage drop, and as such it may include features to improve voltage reading, e.g. a voltage drop. For example, the ohmic portion may have a higher resistivity than the rest of the bus bar. The first portion 13 may comprise for example a resistor, e.g. a shunt resistor 14. For example the shunt resistor may show higher resistivity than the rest of the bus bar made of e.g. copper. The shunt resistor joins the material of the bus bar at two opposite sides or interfaces. The sensor 20 may comprise probes 21 to measure the voltage drop at the first portion 13, e.g. through the resistor 14. The probes can be placed on the bus bar, at each side of the shunt resistor.

A second portion 15, or 'magnetic portion', may include features to optimize generation of magnetic field. For example, the second portion may include a portion with reduced cross section of the bus bar, such as a necking or narrowing 16 provided in the bar, or even a hole. Preferably the cross section is reduced, to increase the generated field. In some embodiments, the second portion may include a narrowing and a hole, e.g. a hole within the narrowing, even. The sensor 20 includes sensing elements to measure the magnetic field.

Two signals are obtained, both representative of the current 30, one from the magnetic sensing elements of the sensor 20 placed on the second portion 15, and another from the voltage drop sensed through the shunt of the first portion 13 by corresponding voltage probes. These redundant signals can be used to increase the safety of the system, compensate errors and improve current measurement accuracy. Signal processing, data fusion algorithms and the like can be used to effectively combine outputs of multiple sensors (including compensating one measurement with another), enhancing the performance.

A resistor, or in general a portion with higher resistance, dissipates energy when a current flows through it due to Joule effect. The temperature changes at the resistor. There is an effect of the temperature shift on the resistivity. Hence, the material of the shunt resistor can be carefully chosen so that the temperature contribution is small and can be disregarded. However, this additionally creates a temperature difference between the shunt and the material of the bus bar adjacent thereto. This temperature difference causes a voltage offset at the electrical junction between the two conducting materials, i.e. the material of the shunt and the material of the bus bar, due to the so-called Seebeck effect. The offset contributes to the difference of potential across shunt, reducing the accuracy of the voltage measurement indicative of the current.

The present invention aims to improve the accuracy of current measurements in a bus bar, by compensating the thermal flux through the shunt, thereby reducing the offset voltage caused by the Seebeck effect. This is achieved by designing the bus bar with a thermally symmetrical structure.

As used herein, and unless otherwise specified, the term "thermally symmetrical structure" refers to a design, layout or arrangement of components that results in a balanced distribution of heat flux. In the context of the bus bar, a thermally symmetrical structure ensures that the thermal resistance from the shunt resistor to the first and second terminals is equal, minimizing any temperature gradients that could affect the accuracy of current measurements. This can be provided by adapting the geometry and/or other physical characteristics of the bus bar so that the thermal resistance between a first terminal and the closest interface between bus bar and shunt is equal to the thermal resistance between the second terminal and the corresponding closest interface between bus bar and shunt.

The bus bar in Fig. 1 shows the ohmic portion 13 at one side of the magnetic portion 15. This means that there is a hot spot only on one side of the bus 10. The bus bar in Fig. 1 is not thermally symmetrical. The heat flux will tend to flow to the most efficient heat sink, thus towards the left side of the bus bar, away from the part with the necking 16, since the portion with the necking presents higher thermal resistance. The Seebeck effect generates an offset on the potential which will be different, e.g. greater, at one interface than at the other, since the thermal flux is higher at the interface 17 between the shunt resistor 14 and bus bar portion at the left (comprising the terminal 12) than at the interface 18 at the right side of the shunt, where the necking 16 is present.

The present invention aims for a compensation of this effect by design of the bus bar, which is adapted to provide thermal symmetry. This can be obtained by providing additional features that make thermal resistances the same from the point of view of each terminal towards the interface with the shunt. For example, multiple magnetic and/or ohmic portions can be provided so that the thermal resistance of the different portions are the same, and/or the thermal flux between these portions cancel each other. For example, two magnetic portions may be provided around an ohmic portion. Alternatively, two ohmic portions may be provided on each side of a magnetic portion. In some embodiments, two neckings or holes may be provided around a central shunt, or two shunts may surround a central necking or hole. Despite the additional portion, the voltage sensing can be obtained in one ohmic portion, and the magnetic sensing can take place over a single magnetic portion. Thus although the further portion may include additional sensing means, it may be left without, to reduce costs. In other words, the voltage and magnetic field are measured as before in bus bar portions adapted to optimize these measurements, and an additional 'dummy' portion is added (a dummy necking, or a dummy shunt resistor, among other embodiments) to balance the thermal resistance and provide a thermally symmetric structure, not necessarily to provide additional sensing spots.

Since more accuracy can be obtained regardless of the shunt temperature, since its effect on the voltage is compensated, the present invention allows sensing of high currents very accurately, even more so than with existing bus bars. Higher frequency currents can also be measured with a high stability.

In the first aspect, the present invention relates to a bus bar with such thermally symmetrical structure, which can be used in combination with a redundant sensor.

Fig. 2 shows a bus bar 100 with a first and second terminals 101, 102 which can be electrical contacts, or holes as shown in the drawing, e.g. for lugs, or zones for clamping or the like. The bus bar further comprises a first portion 110 being a first conductive portion (ohmic portion) which includes a shunt resistor 111. The bus bar 100 may be made of a first conductive material and the shunt resistor from another conductive material, with different resistance. Two junctions 113, 114 are formed between the material of the shunt resistor and the material of the rest of the bus bar. The bus bar comprises a second conductive portion 120, or 'magnetic portion', wherein the bus bar 100 is adapted for generating a measurable magnetic field. The magnetic portion may comprise features, for example geometry, which increases current density. This could be provided, for example, by reducing the cross section of the bus bar in the magnetic portion, for example by providing a narrowing, a hole, etc.

The bus bar 100 has a thermally symmetrical structure configured to balance thermal flux, including elements designed to provide a thermal resistance at a first side of one of the at least one shunt resistor 111 from a first terminal 102, being the same as the thermal resistance at the second side of one of the at least one shunt resistor, in the case of Fig. 2 a further resistor 131, towards a second terminal 101. Thus, two additional junctions are provided. This configuration improves thermal performance and reduced offset. The arrows A, B indicate the direction of the net thermal flux, away from the magnetic portion 120, thus providing the same offset in opposite directions along the bus bar. More in detail, the potential drop R1*i1+dV1 at the first ohmic portion 110 has an offset due to the Seebeck effect dV1, but this parasitic Seebeck voltage can be compensated by the offset dV2 caused by the addition of the further ohmic portion 130 which has a different sign. This can be done for example by summing the voltage drop (v1-v2) at the first ohmic portion 110 to the voltage drop (v3-v4) at the second ohmic portion 130 which as the effect to cancel or at least reduce the offset and also double the useful sensing signal. A compensated output signal Vout indicative of the current can be derived by the following combination, which is substantially independent of the offsets: $Vout = v 1 - v 2 + v 3 - v 4 = R 1 * i 1 + dV 1 + R 2 * i 1 - dV 2 = 2 Ri$

In the particular embodiment of Fig. 2, the bus bar 100 is geometrically symmetrical, with a necking 121. Magnetic sensing means 300, e.g. a magnetic sensor, is aligned with the magnetic portion (e.g. with the necking). A shunt resistor 111 is provided on a side of the bus bar 100, at a given distance from the magnetic portion 120. At the same distance of the magnetic portion120, on the opposite side, another shunt resistor 131 is provided. Hence the shunt resistors are at the same distance from the necking, and the shunt resistors are substantially the same, so the thermal flux is the same across both resistors, but in opposite directions away from the necking, so the Seebeck voltage on each shunt resistor 111, 131 has different signs. A balanced thermal flux in opposite directions can be obtained so they substantially cancel each other along the one or more shunts, or at least reduce the effective total offset, so that there is little or no offset voltage due to the Seebeck effect.

In summary, the offset voltage due to the Seebeck effect at the junction of a shunt is reduced, allowing accurate redundant sensing. The thermal flux away from the magnetic portion generates a voltage offset in a first shunt resistor due to the Seebeck effect, but since there is another shunt resistor at the other side of the magnetic portion, there is a mirror thermal flux generating another voltage offset, but in an opposite direction, thus compensating the measured offset voltage.

In general, the structure may comprise two portions (both ohmic or magnetic) with the same thermal resistance surrounding another portion (respectively magnetic or ohmic). This ensures equal thermal resistance around from the portion surrounded by the other two of different kind. This allows accurate magnetic field measurement.

As explained with reference to Fig. 2, the further portion may comprise a shunt resistor 111 so as to show the same thermal resistance as the first portion. This balances the thermal resistance on both sides. In embodiments, the bus bar 100 may be symmetrical over its center. Symmetry simplifies the design and improves performance. Shaping of the bus bar can be reduced by including an additional shunt.

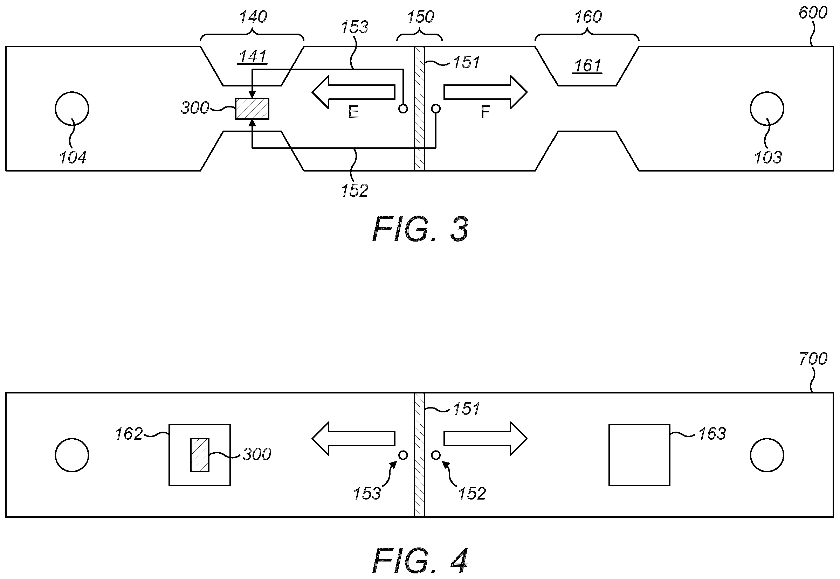

Alternatively, as shown in Fig. 3, the bus bar 600 may comprise a first conductive portion being an ohmic portion 150 surrounded by a magnetic portion 140 and a further magnetic portion 160. A single shunt can be provided, thus reducing the number of junctions along the bus bar. The thermal resistance between a first terminal 103 and the ohmic portion 150 is the same as the same thermal resistance from the second terminal 104 along the bus bar 100 to the ohmic portion 150. Thus, the thermal resistance is the same at each sides of the ohmic portion 150. This provides balanced thermal flux on both sides of the shunt resistor 111, since the thermal fluxes are the same so the Seebeck effect is the same on both interfaces, cancelling or reducing offset voltage.

In particular, the bus bar in Fig. 3 shows a central shunt resistor 151 on the bus bar 100, and two neckings 141, 161 are provided, one at each side of the shunt resistor 151 and at the same distance thereof. It is noted that the magnetic sensing means 300, e.g. a magnetic sensor, may measure the magnetic field of only one of the magnetic portions 140. The voltage drop due to the resistor 151 is measured by the probes 152, 153 which contact the bus bar at each side of the resistor 151. The signal can be sent through the same circuitry as the magnetic sensing means 300, for example to the same IC, or to a different circuitry in another platform, e.g. in an MCU.

The thermal flux from the ohmic portion 150 towards each of the magnetic portions 140, 160 is indicated by arrows E, F. Since the thermal resistance is the same at both sides of the ohmic portion 150, the fluxes E, F are equal and flow in opposite directions, so there is no temperature gradient across the ohmic portion 150. The offset due to the Seebeck effect is compensated and the only contribution for the voltage drop can be considered to originate from the known resistance of the ohmic portion and the current through the bus bar.

In embodiments, the two neckings may have different area and the shunt may be closer to the necking with smaller area. As required by each particular application, asymmetric necking sizes can be compensated by shunt placement.

It is noted that the necking is only one way of providing a measurable magnetic field using the current through the bus bar. For example, providing a reduction of the cross section by addition of a through hole on the largest surfaces of the bus bar, instead of a necking. The hole creates two parts of the bus bar with a reduced cross section. Magnetic sensing elements (e.g. included in a sensor) can be provided aligned with the hole, for example over or within said hole of the bus bar.

Fig. 4 shows a bus bar 700 in which instead of a necking 121, a hole 162 can be used on at least one of the magnetic portions. In embodiments, the bus bar 100 may comprise two holes 162, 163 and a shunt resistor 151 between the magnetic portions with holes 162, 163. Magnetic sensing means, e.g. a packaged sensor 300 with magnetic sensing elements may be aligned at one hole 162, the other hole 163 being a dummy hole without sensing means. A voltage sensing circuit may sense, as before, the voltage across the shunt resistor 151 and the field on one of the magnetic portions, e.g. the field formed only one hole 162. Only the contact points of the probes 152, 153 are shown, to avoid cluttering. In embodiments, the two holes may have the same area and the shunt resistor 151 may be at the same distance of each holes. Equal hole size and shunt placement enhance symmetry.

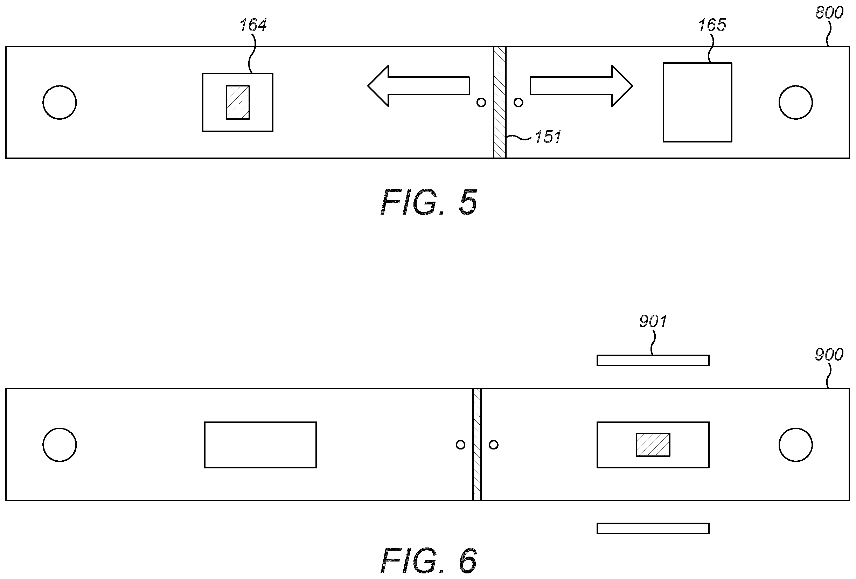

However, the bus bar does not need to be geometrically symmetric, as long as it is thermally symmetric. For example, Fig. 5 shows a bus bar 800 wherein the holes 164, 165 are at a different distance from the shunt resistor 111, and one of the holes 165 is larger. Geometrically asymmetric hole sizes can be compensated by shunt placement.

It is noted that the magnetic portion and further magnetic portion discussed in previous figures show the same features to provide a measurable magnetic field. Alternatively, they may comprise different features. For instance, a magnetic portion may comprise a hole and the other portion may comprise a narrowing. These should be adapted so that their thermal resistance is the same and the thermal structure remains symmetrical. Combining neckings and holes provides design flexibility.

In embodiments, the bus bar may include magnetic shielding. Shielding improves the magnetic field measurement accuracy.

Fig. 6 shows a bus bar 900 with two magnetic portions and an ohmic portion in the middle of the two. In this case the magnetic portions include a hole each. The magnetic portion and the magnetic sensing means provided therein are shielded by a U-shaped plate 901 acting as shield of external magnetic fields. The magnetic sensing means may be or comprise an IMC-Hall sensor.

In embodiments, the shunt resistor may be made of a material with a low temperature coefficient. This reduces temperature-induced measurement errors.

In embodiments, the shunt resistor may comprise manganese, e.g. a manganese alloy. Manganese provides a suitable low temperature coefficient, thus further reducing offset voltage.

In some embodiments wherein two shunt resistors are provided, the shunt resistors may have substantially the same characteristics of resistance. If they had not, the positioning relative to the terminals and magnetic portion should be adjusted so as to provide the bus bar a thermally symmetrical structure.

In embodiments, the bus bar may be made of copper. Copper offers high conductivity and ease of manufacturing.

In the second aspect, the present invention relates to a system for measuring current, comprising a bus bar in accordance with embodiments of the first aspect, and a redundant sensing system. Such system includes a voltage sensing circuit configured to obtain a voltage drop on the first portion through the shunt, and magnetic sensing means configured to measure the magnetic field at the second portion.

The magnetic sensing means may comprise magnetic sensing elements that provide differential measurement. A pair of magnetic sensing elements may be provided, spaced apart, and the signals of each sensing element provides an indication of the magnetic field. In some embodiments, Hall effect sensing elements, combined or not with integrated magnetic concentrators, can be used, the present invention not being limited thereto, and other sensing elements can be used, e.g. based on magnetoresistance.

Further, the system includes a processing unit configured to process the signals from the voltage sensing circuit and magnetic sensing means, to determine the current flowing in the bus bar.

This system enables accurate and redundant current measurement. The voltage sensing circuit and magnetic sensing means may be provided as separate units, or integrated in a single chip.

In embodiments, the magnetic sensor can transmit at least two of the following:
- A signal derived from magnetic sensing means (e.g. an analog or digital signal indicative of the current in the conductor).
- A signal derived from the shunt interface (e.g. voltage drop),
- A signal indicative of a comparison between the above two signals, e.g. a fault signal in case they are not within an error margin of one another.

In some embodiments, the magnetic sensor transmits the three signals listed above, and a redundant comparison may be done in the microcontroller.

In embodiments, the magnetic sensing means may be implemented in a sensor that receives the signals from the probes on each side of the shunt, so the voltage signal through the shunt (Vshunt) may also be routed and optionally processed in the same sensor. Physically, the magnetic sensing means may be provided on an integrated circuit (IC) chip, wherein the signals from the magnetic measurements are processed in a different processing unit. The signals of the voltage sensing circuit may be processed in the same IC, or also in the processing unit. In embodiments, the voltage sensing circuit and magnetic sensing means are be provided in the same integrated circuit. Such integration may save space, allowing more compact current sensors. It may also reduce costs in materials and assembly time.

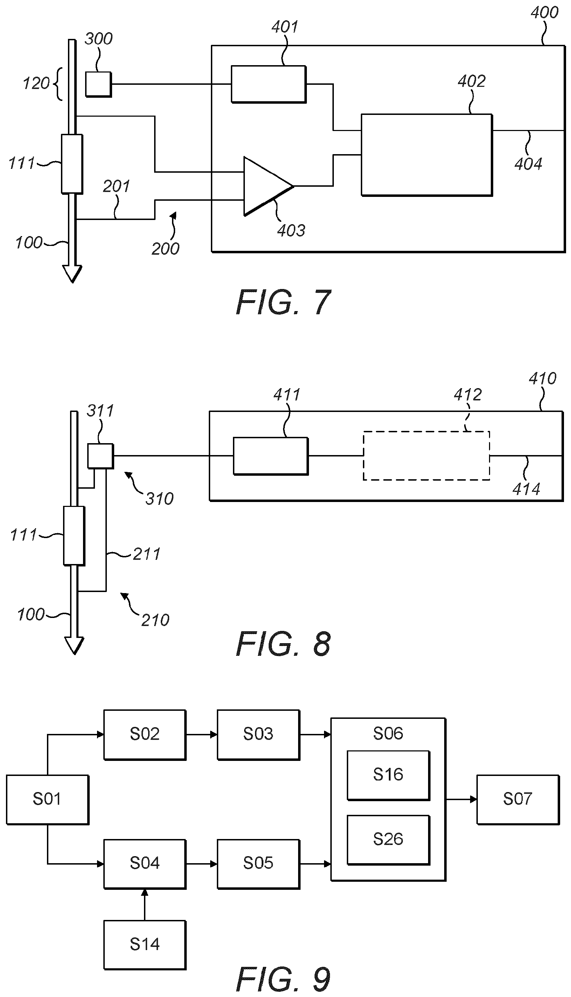

Fig. 7 shows a schematic layout of the sensing system, including a processor or processing circuit 400 with magnetic sensing means 300 provided as a sensor (e.g. packaged Hall-effect integrated circuit) connected to a signal acquisition circuit 401 (e.g. ADC or digital interface) and a processing unit 402, which may be a comparator, checker unit... On the bus bar 100, at each side of the shunt resistor 111, voltage sensing circuit 200 comprising voltage probes 201 obtains the signal of the voltage, which is also sent to the processing unit 402.

More in detail, the magnetic sensor is provided on the magnetic portion 120 of the bus bar 100. The signal acquisition circuit is provided on the processing circuit 400 which may be an external MCU (micro-controller unit), and receives the signal from the magnetic sensor. On the other hand, two probes 201 are placed at respective sides of the shunt resistor 111 of the bus bar. The signals of each probe are sent to the processing circuit 400, for example to an amplifier 403 provided on the processing circuit 400. A processing unit 402 processes the signals from the signal acquisition circuit and from the amplifier. The unit 402 can be integrated in the same processing circuit 400 as the signal acquisition circuit. The unit 402 may be e.g. a checker and/or a combiner which processes together the signals, e.g. provides a signal combined from the signals representative of the magnetic field and the signals representative of the voltage drop to obtain the current, or compares one signal with another for compensation or correction, or error detection, etc. Optionally, the output of the unit 402 unit can be sent to a communication interface 404, e.g. on the processing circuit, for signal output.

The magnetic sensor and processing circuit may be both connected to a substrate, for example a PCB or the like, including any required power source, input, output, conductive tracks. etc. The substrate can be fixed relative to the bus bar.

Fig. 8 shows an alternative schematic layout of the sensing system.

Magnetic sensing means 310 are provided on a chip 311, for example a packaged semiconductor chip. The chip is aligned on the magnetic portion of the bus bar 100 as before. The voltage drop is measured across a shunt resistor 111 using probes 211. In this case however, the signal of probes 211 are also transmitted to the chip 311. Thus, the voltage sensing circuit 210 and the magnetic sensing means 310 can be provided on a chip 311, for example a single chip. The chip 311 can for example be provided as a CMOS integrated circuit and implement circuity to process the voltage drop from the shunt resistor and the magnetic sensor. This circuitry may include one or more differential amplifiers, e.g. for sensing of the voltage drop, analog-to-digital converters and a digital signal processor, for example. Signals from the single chip 311 can be sent to a processing circuit 410, for example to a signal acquisition circuit 411. The signal acquisition circuit may be an ADC, digital interface, etc. It processes the signal and provides it to an optional communication interface 414. Optionally, a further unit 412 (checker circuit, combiner, etc.) can further process the signal before the communication interface provides the output.

In some embodiments of the present invention, some parts of the circuitry for processing the sensing signal of the voltage probes and the circuitry for processing the sensing signal of the magnetic sensor may be different. For instance, they each may have a separate amplifier, signal processing unit, etc. Thus, the signal processing path of the shunt resistor is at least partially independent and/or at least partially separate from the signal processing path of the magnetic sensor.

In the third aspect, the present invention relates to a method of measuring current using a bus bar 100, the method comprising basically measuring the current using two different methods, by measuring the magnetic field generated by the current and the voltage generated by the current across the shunt resistance. The layout of the bus bar in accordance with the first aspect allows compensation of the offset caused by the Seebeck effect of the interfaces of the shunt resistor.

Fig. 9 is a schematic diagram of a method of the third aspect. The method comprises:
- providing S01 a bus bar 100 according to any embodiments of the first aspect,
- measuring S02 the voltage drop through the shunt resistor 111 and providing S03 a voltage signal therefrom, and
- measuring S04 the magnetic field at the second portion 120 and providing S05 a magnetic signal therefrom,
and estimating S06 the current through the bus bar 100 based on the provided voltage and magnetic signals.

This method allows for redundant current measurement with improved accuracy. Since the bus bar is thermally symmetrical, the contribution of the voltage offset caused by Seebeck effect does not affect the signal. The measurement of the voltage drop is very accurate since it does not have the contribution of the offset voltage at the interface between the shunt and the bus bar, e.g. it is compensated.

In embodiments, the estimating S06 the current may further comprise combining S16 the two signals to provide a reading of the current. Combining the signals improves accuracy and reliability. In some embodiments, the method comprises comparing S26 the two signals, either with or without combining them. Comparing the signals obtained by the different sensing means allows obtaining a signal indicative of a fault in some embodiments. This comparison can be done by the electronics of chip 311, or of the integrated circuit 400. A difference larger than a threshold may indicate a problem with the system, such as a sensing failure (for example, break of the electrical connections or probes, failure of the magnetic sensor, failure of an element for signal processing). In some embodiments, current sensing can still be provided if one of the sensing processing paths fails, e.g. in embodiments wherein the signal processing path of the voltage sensing is different from the signal processing path of the magnetic sensing, as explained earlier.

The signal representative of the current through the bus bar can be sent S07 to an output. Additionally or alternatively, an error signal can be sent to the output, for example when the result of the comparison indicates different currents beyond an error margin, which allows for example providing error detection.

In embodiments, measuring the magnetic field may comprise using a Hall effect sensor. Hall sensors are well-suited for contactless current measurement. The method may optionally include shielding S14 the sensor.

In the fourth aspect, the present invention relates to a kit of parts for measuring current, comprising:
- a bus bar 100 according to embodiments of the first aspect,
- voltage sensing circuit 200 configured to obtain a voltage drop through the shunt resistor 111 and a magnetic sensor configured to measure the magnetic field at the necking 121 or hole,
- a processor connectable to the voltage sensing circuit 200 and magnetic sensing means 300.

This kit enables easy assembly of the current measurement system. In some embodiments, the processor is provided as an electronic unit, for example MCU. In some embodiments, the magnetic sensor is provided on an IC.

In some embodiments, the magnetic sensing means and voltage sensing circuit are integrated in a single IC chip or a single packaged chip. Alternatively, the voltage sensing circuit are implemented on a different unit. For example, the voltage sensing circuit may be provided on the electronic unit including the processor, e.g. the MCU.

The kit may comprise a U-shaped plate to be used as magnetic shielding around the magnetic portion.

The present invention allows sensing of currents with improved thermal performance, thus enabling sensing of high currents accurately. The higher accuracy is provided by the redundancy, and the redundant measurement is in turn improved by the thermally symmetrical structure of the bus bar.

The bus bar may comprise a plurality of portions with different features, for example geometric features, resistances (such as resistors), and the like which provide tailored thermal resistances, such that the thermal flux through the interface of a shunt closest to a terminal, generates a offset voltage which is cancelled by the offset voltage caused by the thermal flux through a different interface of the same or a different shunt.

The bus bar does not need to be geometrically symmetric, as long as it is thermally symmetric. Neckings, holes, even a combination thereof can be at different distances from the shunt, and one of the holes can be larger without compromising the thermal symmetry. Alternatively, two shunt resistors may be provided, which may be at the same distance from the magnetic portion if they have the same characteristics. If the characteristics are different, the distance between the magnetic portion and one of the resistors may be different than the distance to the other resistor.

By employing thermally symmetrical structures in the bus bar, such as strategically placed shunt resistors, neckings, and holes, the measurement errors caused by the Seebeck effect at the shunt-bus bar interface can be minimized. The combination of voltage sensing through the shunt resistor and magnetic field measurement at the necking or hole provides a reliable and accurate means of determining the current in the bus bar.

The bus bar may comprise multiple ohmic and magnetic portions, not only one of one kind and two of the other. As long as there is thermal symmetry, the offset can be at least partially compensated thus providing better current sensing. For example, a bus bar may comprise three or more shunt resistors positioned at equal intervals along its length. Between a shunt resistor and an adjacent shunt resistor, a necking is provided. The necking or neckings are distributed and designed to have the same cross-sectional area and are equidistant from the adjacent shunt resistors. Magnetic sensors are placed over one or two of the neckings, while the third necking serves as a reference for thermal symmetry. Alternatively, holes may be used rather than neckings. Optionally, the holes may have different sizes, between shunts at different distances.

Two resistors can be provided with accurate resistances, however in some embodiments it may be preferable to provide a bus bar with only one shunt resistor and two magnetic portions, for ease of manufacture.

It is to be understood that although preferred embodiments, specific constructions and configurations, as well as materials, have been discussed herein for devices according to the present invention, various changes or modifications in form and detail may be made without departing from the scope of this invention. For example, any formulas given above are merely representative of procedures that may be used. Functionality may be added or deleted from the block diagrams and operations may be interchanged among functional blocks. Steps may be added or deleted to methods described within the scope of the present invention.

## Claims

1. A bus bar (100) with a first and second terminals (101, 102), comprising at least one shunt resistor (111) for generating a voltage drop across the shunt resistor, a first portion (110) being a first conductive portion comprising the shunt resistor, and a second portion (120) being a second conductive portion, wherein the bus bar is adapted for generating a measurable magnetic field at said second conductive portion, **characterised by** the bus bar (100) having a thermally symmetrical structure configured to balance thermal flux, including elements designed to provide a thermal resistance at a first side of one of the at least one shunt resistor from a first terminal (101) being the same as the thermal resistance at the second side of one of the at least one shunt resistor towards a second terminal (102).

2. The bus bar according to claim 1, further comprising a further portion (160) with the same thermal resistance as the second portion (140) along the bus bar at each sides of the first conductive portion (150).

3. The bus bar according to any one of the previous claims, further comprising a further portion (130) with the same thermal resistance as the first portion (110) surrounding the second portion (120).

4. The bus bar according to claim 2 wherein each of the second and further portions (140, 160) comprise a hole, a narrowing (161), or a combination of both.

5. The bus bar according to claim 3 wherein the further portion comprises a shunt so as to show the same thermal resistance as the first portion.

6. The bus bar according to any one of the previous claims, wherein the bus bar is symmetrical over its center.

7. The bus bar according to any one of the previous claims, wherein the shunt resistor (110) is made of a material with a low temperature coefficient.

8. The bus bar according to any one of the previous claims, wherein the shunt resistor (110) comprises manganese.

9. The bus bar according to any one of the previous claims, wherein the bus bar is made of copper.

10. A system for measuring current, comprising:
- a bus bar (100) in accordance with any one of the previous claims,
- a voltage sensing circuit (200) configured to obtain a voltage drop on the first portion through the shunt and a magnetic sensing means (300) configured to measure the magnetic field at the second portion (120), and
- a processing circuit (400) configured to process the signals from the voltage sensing circuit and magnetic sensing means to determine the current flowing in the bus bar.

11. The system according to claim 10, wherein the voltage sensing circuit and magnetic sensing means are provided in the same integrated circuit (311).

12. A method of measuring current using a bus bar, the method comprising:
- providing (S01) a bus bar according to any one of claims 1 to 9,
- measuring (S02) the voltage drop through the shunt and providing (S03) a voltage signal therefrom, and
- measuring (S04) the magnetic field at the second portion and providing (S05) a magnetic signal therefrom,
and estimating (S06) the current through the bus bar based on the provided voltage and magnetic signals.

13. The method according to claim 12, further comprising combining (S16) and/or comparing (S26) the two signals to provide a reading of the current.

14. The method according to any one of claims 12 to 13, wherein measuring the magnetic field comprises using a Hall effect sensor.

15. A kit of parts for measuring current, comprising:
- a bus bar (100) according to claims 1 to 9 ,
- a voltage sensing circuit (200) configured to obtain a voltage drop through the shunt and a magnetic sensing means (300) configured to measure the magnetic field at the necking or hole,
- a processor (400) connectable to the voltage sensing circuit and the magnetic sensing means.

## Patentansprüche

1. Eine Stromschiene (100) mit einem ersten und zweiten Anschluss (101, 102), umfassend mindestens einen Shunt-Widerstand (111) zum Erzeugen eines Spannungsabfalls über den Shunt-Widerstand, wobei ein erster Abschnitt (110) ein erster leitender Abschnitt ist, der den Shunt-Widerstand umfasst, und ein zweiter Abschnitt (120) ein zweiter leitender Abschnitt ist, wobei die Stromschiene zum Erzeugen eines messbaren Magnetfelds am zweiten leitenden Abschnitt angepasst ist, **dadurch gekennzeichnet ist, dass** die Stromschiene (100) eine thermisch symmetrische Struktur aufweist, die konfiguriert ist, um den Wärmefluss auszugleichen, die Elemente beinhaltet, die ausgelegt sind, um einen Wärmewiderstand auf einer ersten Seite von einem des mindestens einen Shunt-Widerstands von einem ersten Anschluss (101), welcher der gleiche wie der Wärmewiderstand auf der zweiten Seite von einem des mindestens einen Shunt-Widerstands in Richtung eines zweiten Anschlusses (102) ist, bereitzustellen.

2. Die Stromschiene nach Anspruch 1, weiter umfassend einen weiteren Abschnitt (160) mit dem gleichen Wärmewiderstand wie der zweite Abschnitt (140) entlang der Stromschiene auf jeder Seite des ersten leitenden Abschnitts (150).

3. Die Stromschiene nach einem der vorstehenden Ansprüche, weiter umfassend einen weiteren Abschnitt (130) mit dem gleichen Wärmewiderstand wie der erste Abschnitt (110), der den zweiten Abschnitt (120) umgibt.

4. Die Stromschiene nach Anspruch 2, wobei jeder von dem zweiten und weiteren Abschnitten (140, 160) ein Loch, eine Verengung (161) oder eine Kombination aus beidem umfasst.

5. Die Stromschiene nach Anspruch 3, wobei der weitere Abschnitt einen Shunt umfasst, um den gleichen Wärmewiderstand wie der erste Abschnitt aufzuzeigen.

6. Die Stromschiene nach einem der vorstehenden Ansprüche, wobei die Stromschiene über ihre Mitte symmetrisch ist.

7. Die Stromschiene nach einem der vorstehenden Ansprüche, wobei der Shunt-Widerstand (110) aus einem Material mit niedrigem Temperaturkoeffizienten gefertigt ist.

8. Die Stromschiene nach einem der vorstehenden Ansprüche, wobei der Shunt-Widerstand (110) Mangan umfasst.

9. Die Stromschiene nach einem der vorstehenden Ansprüche, wobei die Stromschiene aus Kupfer gefertigt ist.

10. Ein System zur Strommessung, umfassend:
- eine Stromschiene (100) nach einem der vorstehenden Ansprüche,
- eine Spannungserfassungsschaltung (200), die konfiguriert ist, um einen Spannungsabfall am ersten Abschnitt über den Shunt zu erhalten, und ein magnetisches Erfassungsmittel (300), das konfiguriert ist, um das Magnetfeld am zweiten Abschnitt (120) zu messen, und
- eine Verarbeitungsschaltung (400), die konfiguriert ist, um die Signale von der Spannungserfassungsschaltung und dem magnetischen Erfassungsmittel zu verarbeiten, um den in der Stromschiene fließenden Strom zu bestimmen.

11. Das System nach Anspruch 10, wobei die Spannungserfassungsschaltung und das magnetische Erfassungsmittel in der gleichen integrierten Schaltung (311) bereitgestellt sind.

12. Ein Verfahren zur Strommessung unter Verwendung einer Stromschiene, wobei das Verfahren umfasst:
- Bereitstellen (S01) einer Stromschiene nach einem der Ansprüche 1 bis 9,
- Messen (S02) des Spannungsabfalls über den Shunt und Bereitstellen (S03) eines Spannungssignals daraus, und
- Messen (S04) des Magnetfelds am zweiten Abschnitt und Bereitstellen (S05) eines Magnetsignals daraus,
und Schätzen (S06) des Stroms durch die Stromschiene basierend auf den bereitgestellten Spannungs- und Magnetsignalen.

13. Das Verfahren nach Anspruch 12, weiter umfassend Kombinieren (S16) und/oder Vergleichen (S26) der beiden Signale, um einen Messwert des Stroms bereitzustellen.

14. Das Verfahren nach einem der Ansprüche 12 oder 13, wobei Messen des Magnetfelds Verwenden eines Hall-Effekt-Sensors umfasst.

15. Ein Kit aus Teilen zur Strommessung, umfassend:
- eine Stromschiene (100) nach den Ansprüchen 1 bis 9,
- eine Spannungserfassungsschaltung (200), die konfiguriert ist, um einen Spannungsabfall über den Shunt zu erhalten, und ein magnetisches Erfassungsmittel (300), das konfiguriert ist, um das Magnetfeld an der Verengung oder am Loch zu messen,
- einen Prozessor (400), der mit der Spannungserfassungsschaltung und den magnetischen Erfassungsmitteln verbindbar ist.

## Revendications

1. Barre omnibus (100) avec des première et deuxième bornes (101, 102), comprenant au moins une résistance shunt (111) pour générer une chute de tension à travers la résistance shunt, une première portion (110) étant une première portion conductrice comprenant la résistance shunt, et une deuxième portion (120) étant une deuxième portion conductrice, dans laquelle la barre omnibus est adaptée pour générer un champ magnétique mesurable à ladite deuxième portion conductrice, **caractérisée en ce que** la barre omnibus (100) présente une structure thermiquement symétrique configurée pour équilibrer le flux thermique, comprenant des éléments conçus pour fournir une résistance thermique à un premier côté de l'une de l'au moins une résistance shunt depuis une première borne (101) qui est identique à la résistance thermique au deuxième côté de l'une de l'au moins une résistance shunt vers une deuxième borne (102).

2. Barre omnibus selon la revendication 1, comprenant en outre une portion supplémentaire (160) ayant la même résistance thermique que la deuxième portion (140) le long de la barre omnibus de chaque côté de la première portion conductrice (150).

3. Barre omnibus selon l'une quelconque des revendications précédentes, comprenant en outre une portion supplémentaire (130) ayant la même résistance thermique que la première portion (110) entourant la deuxième portion (120).

4. Barre omnibus selon la revendication 2, dans laquelle chacune des deuxième et supplémentaire portions (140, 160) comprend un trou, un rétrécissement (161), ou une combinaison des deux.

5. Barre omnibus selon la revendication 3, dans laquelle la portion supplémentaire comprend un shunt de manière à présenter la même résistance thermique que la première portion.

6. Barre omnibus selon l'une quelconque des revendications précédentes, dans laquelle la barre omnibus est symétrique par rapport à son centre.

7. Barre omnibus selon l'une quelconque des revendications précédentes, dans laquelle la résistance shunt (110) est constituée d'un matériau à faible coefficient de température.

8. Barre omnibus selon l'une quelconque des revendications précédentes, dans laquelle la résistance shunt (110) comprend du manganèse.

9. Barre omnibus selon l'une quelconque des revendications précédentes, dans laquelle la barre omnibus est constituée de cuivre.

10. Système de mesure de courant, comprenant :
- une barre omnibus (100) selon l'une quelconque des revendications précédentes,
- un circuit de détection de tension (200) configuré pour obtenir une chute de tension sur la première portion à travers le shunt et des moyens de détection magnétique (300) configurés pour mesurer le champ magnétique à la deuxième portion (120), et
- un circuit de traitement (400) configuré pour traiter les signaux provenant du circuit de détection de tension et des moyens de détection magnétique afin de déterminer le courant circulant dans la barre omnibus.

11. Système selon la revendication 10, dans lequel le circuit de détection de tension et les moyens de détection magnétique sont prévus dans le même circuit intégré (311).

12. Procédé de mesure de courant utilisant une barre omnibus, le procédé comprenant :
- la fourniture (S01) d'une barre omnibus selon l'une quelconque des revendications 1 à 9,
- la mesure (S02) de la chute de tension à travers le shunt et la fourniture (S03) d'un signal de tension à partir de celle-ci, et
- la mesure (S04) du champ magnétique à la deuxième portion et la fourniture (S05) d'un signal magnétique à partir de celui-ci,
et l'estimation (S06) du courant traversant la barre omnibus sur la base des signaux de tension et magnétique fournis.

13. Procédé selon la revendication 12, comprenant en outre la combinaison (S16) et/ou la comparaison (S26) des deux signaux pour fournir une lecture du courant.

14. Procédé selon l'une quelconque des revendications 12 à 13, dans lequel la mesure du champ magnétique comprend l'utilisation d'un capteur à effet Hall.

15. Kit de pièces pour la mesure de courant, comprenant :
- une barre omnibus (100) selon les revendications 1 à 9,
- un circuit de détection de tension (200) configuré pour obtenir une chute de tension à travers le shunt et des moyens de détection magnétique (300) configurés pour mesurer le champ magnétique à l'étranglement ou au trou,
- un processeur (400) pouvant être connecté au circuit de détection de tension et aux moyens de détection magnétique.
